# EUROPÄISCHE PATENTSCHRIFT

(11) **EP 0 818 069 B1**
(45) Veröffentlichungstag und Bekanntmachung des Hinweises auf die Patenterteilung: **25.08.1999**
(21) Anmeldenummer: 96908010.0
(22) Anmeldetag: 29.03.1996
(51) Int. Cl.: H01S 3/103, H01S 3/085, H04B 10/155, H04L 7/00

(54) **SELBSTPULSIERENDER MEHRSEKTIONSLASER**
SELF-PULSING MULTI-SECTION LASER
LASER MULTI SEGMENTS A AUTOIMPULSION

(30) Priorität: 31.03.1995 DE 19513198
(43) Veröffentlichungstag der Anmeldung: 14.01.1998
(73) Patentinhaber: Heinrich-Hertz-Institut für Nachrichtentechnik Berlin GmbH, 10587 Berlin (DE)
(72) Erfinder: SARTORIUS, Bernd, D-14052 Berlin (DE); MÖHRLE, Martin, D-12355 Berlin (DE); FEISTE, Uwe, D-14197 Berlin (DE); HÖRER-DRAGENDORF, Jürgen, D-12435 Berlin (DE)
(74) Vertreter: Rudolph, Margit
(86) Internationale Anmeldenummer: DE9600597
(87) Internationale Veröffentlichungsnummer: WO9630976

(56) Entgegenhaltungen:
- EP-A- 0 300 790
- IEEE PHOTONICS TECHNOLOGY LETTERS, Bd. 4, Nr. 9, 1.September 1992, NEW YORK, US, Seiten 976-978, XP000305539 MOEHRLE M ET AL: "Gigahertz self-pulsation in 1.5um wavelength multisection DFB lasers" in der Anmeldung erwähnt
- IEEE PHOTONICS TECHNOLOGY LETTERS, Bd. 7, Nr. 3, März 1995, NEW YORK, US, Seiten 278-280, XP002007405 G.-H.DUAN ET AL.: "Self-pulsation in multielectrode distributed feedback lasers"
- JOURNAL OF LIGHTWAVE TECHNOLOGY, Bd. 10, Nr. 2, 1.Februar 1992, NEW YORK, US, Seiten 199-205, XP000267491 TAKAHIRO NUMAI: "1.5-um wavelength tunable phase-shift-controlled distributed feedback laser"
- PATENT ABSTRACTS OF JAPAN vol. 011, no. 320 (E-550), 17.Oktober 1987 & JP,A,62 109388 (NEC CORP), 20.Mai 1987,

## Beschreibung

Die Erfindung betrifft einen selbstpulsierenden Mehrsektionslaser, der zwei DFB-Sektionen aufweist.

Für die Signalregeneration in ultraschnellen optischen Telekommunikationsnetzen sind in den letzten Jahren funktionelle Mehrsektions-Laser entwickelt worden, um rein optisch, unter Vermeidung opto-elektronischer Wandlungen, höhere Operationsgeschwindigkeiten mit vereinfachten und kompakteren Signalverarbeitungsmodulen zu erreichen.

Niederfrequente Selbstpulsationen in Halbleiterlasern können dem Stand der Technik nach durch Ausbleichen eines Absorbers z.B. in Drei-Sektions-DFB (Distributed Feedback)-Lasern (ELECTRONICS LETTERS, 10 th November 1988, Vol. 24, No. 23, pp. 1426 - 1427) oder in Zwei-Sektions-Fabry-Perot(FP)-Lasern (IEEE Photonics Technology Letters, Vol. 3, No. 10, October 1991, pp. 942 - 945) erzeugt werden. Die physikalische Geschwindigkeitsgrenze ist direkt korreliert mit der Ladungsträgerlebensdauer in der Absorbersektion. Bei Nutzung absorptiver Effekte sind die Selbstpulsationsfrequenzen deshalb auf einige Hundert MHz bis einige GHz beschränkt. Weiterhin muß die Lebensdauer der Ladungsträger im Absorber kleiner sein als in der Pumpsektion, damit eine Selbstpulsation überhaupt auftreten kann, was eine technologische Sonderbehandlung der Absorbersektion erfordert.

Höhere Selbstpulsationsfrequenzen sind durch Ausnutzen dispersiver Effekte in Zwei-Sektions-DFB-Lasern realisiert worden, bei denen die Gestaltung der einzelnen Sektionen keinen zusätzlichen Aufwand erfordert.

Der Stand der Technik, von dem die Erfindung ausgeht, betrifft einen Mehrsektions-DFB-Laser, der zwei DFB-Sektionen aufweist, und ist in IEEE Photonics Technology Letters, Vol. 4, No. 9, September 1992, pp. 976 bis 978, beschrieben. Die beiden optisch gekoppelten DFB-Sektionen des Mehrsektionslasers weisen die gleiche Schichtstruktur auf und sind in ihrer Längsausdehnung durch einen Ätzgraben elektrisch getrennt. Die Struktur vom Typ eines Rippenwellenleiters weist quaternäre aktive Schichten mit einer Wellenlänge der Bandlücke von 1,55 µm auf. Die DFB-Gitter erster Ordnung wurden holographisch erzeugt und durch einen Naßätzprozeß in die obere Wellenleiterschicht übertragen. Die Facetten der beiden DFB-Sektionen waren nicht beschichtet. Für die Entstehung der Selbstpulsationen in diesem Zwei-Sektions-DFB-Laser sind bestimmte kritische spektrale Korrelationen von Lasermoden in den beiden DFB-Sektionen notwendig, die durch Einstellung bestimmter Kombinationen von Strömen in den beiden Sektionen erreicht werden können.

Mit dem beschriebenen Zwei-Sektions-DFB-Laser wurden eine Größenordnung höhere Pulsationsfrequenzen realisiert als in den oben erwähnten Lasern mit Absorber. Die Pulsationsfrequenz kann dabei rein elektrisch durch Einstellung der Betriebsströme in den Sektionen kontinuierlich über einen großen Frequenzbereich abgestimmt werden. Über Ergebnisse von weiterführenden Arbeiten wird in Proc. of 14th IEEE Intern. Semicond. Laser Conf., September 19-23, 1994, pp. 227-228 berichtet. Eine Optimierung der DFB-Laserstruktur erfolgte dahingehend, daß die aktive Schicht als Multi-Quantum-Well ausgebildet und ein größerer Kopplungskoeffizient des DFB-Gitters realisiert wurde. In einem solchen optimierten Zwei-Sektions-DFB-Laser konnte durch Änderung des Betriebsstromes nur einer DFB-Sektion - bei konstantem Betriebsstrom der anderen Sektion - die Pulsationsfrequenz kontinuierlich zwischen 12 und 64 GHz abgestimmt werden.

Die bisher vorgestellten Ergebnisse sind jedoch nicht beliebig reproduzierbar. Es ist bekannt, daß die Phasenlage des an einer Facette reflektierten Lichtes relativ zum DFB-Gitter die spektrale Charakteristik eines DFB-Lasers erheblich beeinflußt. Bei den durch Spalten erzeugten Facetten ist die entstehende Phasenlage für jeden DFB-Laser eine individuelle, technologisch nicht beherrschbare Größe. Da hochfrequente Selbstpulsationen experimentell bisher nur an DFB-Lasern mit mindestens einer nichtentspiegelten Facette nachgewiesen werden konnten, ist es bisher notwendig, Bauelemente zu selektieren, um Laser mit geeigneter Pulsationscharakteristik zu erhalten. Auch nominell gleiche, direkt benachbart auf einem Chip hergestellte Laser zeigten bezüglich Erzeugung und Eigenschaft (z.B. Frequenz) der Selbstpulsation sehr große Unterschiede.

Aufgabe der Erfindung ist es deshalb, einen selbstpulsierenden Mehrsektionslaser anzugeben, bei dem ohne Selektion eine reproduzierbare definierte Einstellung von Selbstpulsationen mit hoher Frequenz möglich ist.

Die Aufgabe wird erfindungsgemäß dadurch gelöst, daß in einem selbstpulsierenden Mehrsektionslaser der eingangs erwähnten Art ein aus zwei Reflektoren und einem Distanzstück gebildeter FP-artiger Resonator in den Mehrsektionslaser integriert und mit mindestens einer DFB-Sektion optisch gekoppelt ist und das Distanzstück eine ähnliche Schichtstruktur wie die benachbarten DFB-Sektionen, jedoch kein DFB-Gitter, aufweist und als elektrisch von den DFB-Sektionen getrennt betreibbare Steuersektion ausgebildet ist.

Durch die Integration der zusätzlichen Sektion, die mit den als Reflektor wirkenden beiden benachbarten DFB-Sektionen bzw. mit einer benachbarten DFB-Sektion und einer nichtentspiegelten Facette einen Fabry-Perot-(FP)-artigen Resonator bildet, müssen die anschwingenden Lasermoden sowohl den DFB-Modenbedingungen als auch den FP-Modenbedingungen genügen. DFB-Lasermoden, die der Modenbedingung für den FP-Resonator nicht genügen, werden deshalb sehr effektiv ausgeblendet. Sind die Betriebsströme der beiden DFB-Sektionen geeignet für eine Selbstpulsation eingestellt, so kann über die FP-Selektivität die zur Selbstpulsation geeignete Mode gezielt gefördert oder unterdrückt und damit die Selbstpulsation ein- oder ausgeschaltet werden. Über die von den beiden DFB-Sektionen getrennte elektrische Ansteuerung des als Steuersektion ausgebildeteten Distanzstücks kann durch Strominjektion der Brechungsindex in dieser Sektion gezielt verändert werden. Dadurch sind die optische Resonatorlänge und die spektrale Lage der FP-Moden elektrisch einstellbar und die zusätzliche Sektion ohne DFB-Gitter erfüllt die Funktion einer Steuersektion. Damit wurde erstmals ein modenselektiver, elektrisch abstimmbarer optischer Resonator als selbstpulsierender Mehrsektionslaser realisiert.

Außerdem kann die Laserwellenlänge - bei gegebenen festen Strömen in den DFB-Sektionen - elektrisch noch fein über den Steuerstrom abgestimmt werden. Hierdurch ist eine Feineinstellung der Pulsationsbedingungen für z.B. optimale Frequenzstabilität möglich. Diese Optimierung kann variabel, d.h. für jeden Arbeitspunkt neu vorgenommen werden. Eine Abstimmung der Pulsationsfrequenz über die DFB-Ströme kann so über weite Bereiche unter optimalen Pulsationsbedingungen erfolgen, weil die durch (unvermeidliche) Erwärmungseffekte bewirkte Veränderungen der Modenkorrelationen durch Nachziehen des Steuerstromes kompensiert werden können.

Für die Herstellung eines erfindungsgemäßen Mehrsektionslasers sind keine - im Vergleich zur Schichtstruktur der DFB-Sektionen - aufwendigen Technologieschritte notwendig, d.h. mit annähernd gleichem technologischen Aufwand wie bisher für "reine" Zwei-Sektions-DFB-Laser ist der Zwei-Sektions-DFB-Laser mit elektrisch abstimmbarer Steuersektion realisierbar. Eine bisher notwendige Selektion geeigneter DFB-Laserstrukturen entfällt, da über den Strom in der Steuersektion die Pulsation - bei geeigneten Betriebsströmen in den DFB-Sektionen - einfach eingeschaltet wird. Damit sind diejenigen Betriebsbedingungen für optimale Pulsation im Mehrsektionslaser elektrisch gezielt einstellbar, die bisher zufällig und unkontrollierbar vorhanden waren.

In einer Ausführungsform der Erfindung ist das Distanzstück als passive Steuersektion ausgebildet und weist keine aktive Schicht auf. Die passive Steuersektion kann in einer vorteilhaften Ausführungsform zwischen einer den Mehrsektionslaser begrenzenden Facette und einer DFB-Sektion angeordnet sein. Diese Facette ist hierbei nicht entspiegelt, so daß über die einstellbaren Phasenbedingungen im FP-Resonator die Selbstpulsation des Mehrsektionslasers schalt- und optimierbar ist. Die andere Facette kann entspiegelt sein.

Eine andere vorteilhafte Ausführungsform sieht vor, das als passive Steuersektion ausgebildete Distanzstück zwischen den beiden DFB-Sektionen anzuordnen. Beide Facetten, die den Mehrsektionslaser begrenzen, können in dieser Ausführungsform entspiegelt sein. Damit ist eine Integrierbarkeit in optische Schaltkreise möglich.

In den erwähnten Ausführungsformen wird dominierend der Brechungsindex der Steuersektion über den an diese Sektion angelegten Strom bei sonst konstanten Betriebsströmen der beiden DFB-Sektionen verändert.

In einer weiteren Ausführungsform der Erfindung ist das Distanzstück als aktive Steuersektion ausgebildet. Diese weist die gleiche aktive Schicht wie die benachbarten DFB-Sektionen auf und ist zwischen den beiden DFB-Sektionen angeordnet. Bei dieser Ausführungsform wird die Dämpfung oder Verstärkung der Lichtwelle bei nur schwachem Brechungsindex-Effekt durch den Strom gesteuert.

Ist das Distanzstück sowohl aus einer aktiven Steuersektion als auch aus einer passiven Steuersektion gebildet und zwischen den beiden DFB-Sektionen angeordnet - wie in einer anderen Ausführungsform vorgesehen können Brechungsindex und Verstärkung bzw. Dämpfung separat angesteuert werden. Über die aktive Steuersektion kann hier die optische Kopplung der DFB-Sektionen verändert und damit die Pulsationsfrequenz erweitert abgestimmt werden.

Um die kritische DFB-Modenkorrelation gezielt einstellen zu können, die unter normalen Bedingungen durch die unterschiedliche Erwärmung - hervorgerufen durch die in den beiden DFB-Sektionen fließenden unterschiedlich großen Ströme - entsteht, ist in einer weiteren Ausführungsform vorgesehen, daß die Gitter in den beiden DFB-Sektionen verstimmt gegeneinander in der Bragg-Wellenlänge sind. Eine angestrebte Verstimmung kann dadurch mit kleineren Strömen erreicht werden bzw. es können wesentlich größere Verstimmungen realisiert werden.

Ebenfalls über die Struktur des Gitters gestattet eine andere Ausführungsform der Erfindung die getrennte Optimierung der beiden DFB-Sektionen in ihren unterschiedlichen Funktionen, wie z.B. als Lichtemitter und als spektral selektiver Lichtreflektor. So weisen in dieser Ausführungsform die Gitter in den beiden DFB-Sektionen unterschiedlich große Kopplungskoeffizienten auf.

Weitere zweckmäßige Ausgestaltungen der Erfindung sind Gegenstand der Unteransprüche bzw. werden nachstehend zusammen mit der Beschreibung der bevorzugten Ausführungsform der Erfindung anhand der Figuren näher erläutert.

Es zeigen:
- Fig. 1: den schematischen Aufbau eines Mehrsektionslasers, bestehend aus zwei DFB-Sektionen und einer zwischen einer den Mehrsektionslaser begrenzenden Facette und einer DFB-Sektion angeordneten passiven Steuersektion;
- Fig. 2: einen Querschnitt des in Fig. 1 dargestellten Mehrsektionslasers;
- Fig. 3: das Einschalten der Selbstpulsation mit dem Phasenstrom bei einem in Fig. 1 dargestellten Mehrsektionslaser;
- Fig. 4: Selbstpulsationsregime und Wellenlängenabstimmung des in Fig. 1 dargestellten Mehrsektionslasers in Abhängigkeit des Phasenstromes;
- Fig. 5: einen Querschnitt eines Mehrsektionslasers mit einer zwischen den beiden DFB-Sektionen angeordneten passiven Steuersektion;
- Fig. 6: einen Querschnitt eines Mehrsektionslasers mit einer zwischen den beiden DFB-Sektionen angeordneten aktiven Steuersektion;
- Fig. 7: einen Querschnitt eines Mehrsektionslasers mit sowohl einer aktiven als auch einer passiven zwischen den beiden DFB-Sektionen angeordneten Steuersektion.

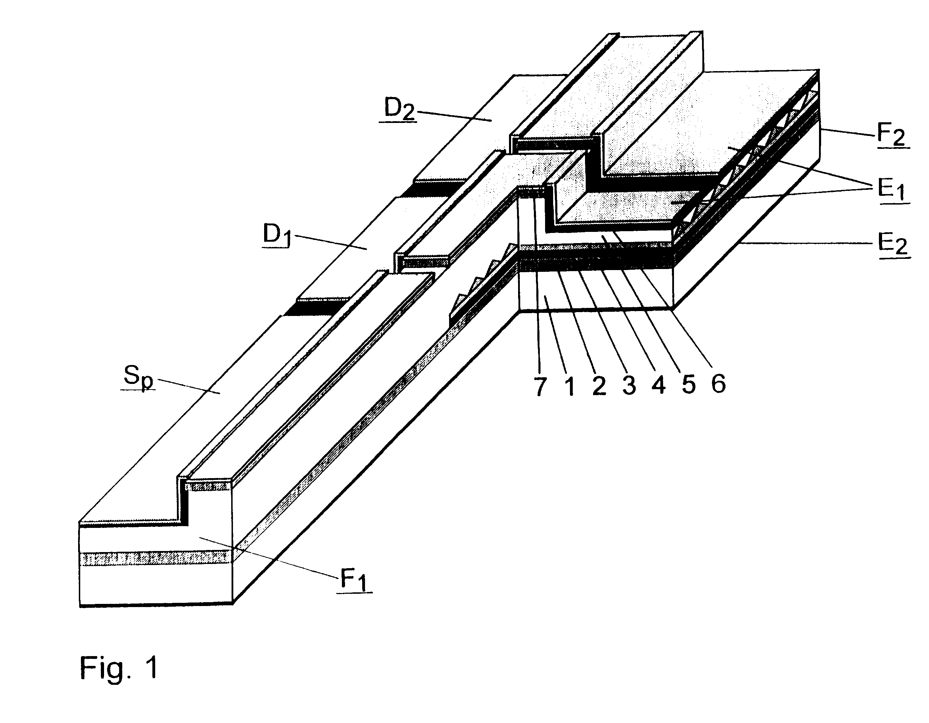

Die Fig. 1 zeigt schematisch den Aufbau eines erfindungsgemäßen Mehrsektionslasers in Rippenwellenleiterstruktur, der aus zwei DFB-Sektionen **D**_{**1**} und **D**_{**2**} und einem zwischen einer den Mehrsektionslaser begrenzenden Facette **F**_{**1**}, die unbeschichtet ist, und der DFB-Sektion **D**_{**1**} angeordneten und als passive Steuersektion **S**_{**p**} ausgebildeten Distanzstücks eines FP-artigen Resonators besteht. Auf einem n-InP-Substrat **1** ist zwischen einer 300 nm dicken n-1,3 µm-InGaAsP-Wellenleiterschicht **2** und einer 150 nm dicken p-1,18 µm-InGaAsP-Wellenleiterschicht **4** eine 1,55 µm-InGaAsP-Schicht als aktive Schicht 3 mit einer Dicke von 150 nm angeordnet. Das DFB-Gitter wurde mittels Elektronenstrahllithographie eingeschrieben und in den p-Wellenleiter **4** geätzt. Darauf befinden sich eine p-InP-Schicht 5 und eine isolierende nur an der Rippe geöffnete SiNₓ-Schicht **6**, die von einer Elektrodenschicht **E**_{**1**} bedeckt ist. Der Mittelstreifen der Rippenwellenleiterstruktur weist außerdem zur Verringerung des Übergangswiderstandes eine 400 nm dicke p-InGaAs-Schicht 7 auf. Die beiden DFB-Sektionen **D**_{**1**} und **D**_{**2**} haben eine Länge von je 200 µm, die passive Steuersektion **S**_{**p**} ist 400 µm lang. Die DFB-Sektion **D**_{**2**} wird von einer antireflexionsbeschichteten Facette F₂ begrenzt. Das Substrat **1** ist auf einer Basiselektrode **E**_{**1**} angeordnet. Die einzelnen Sektionen werden getrennt mit Gleichstrom angesteuert. Eine Strominjektion in der passiven Steuersektion **S**_{**p**} bewirkt hier eine Änderung des Brechungsindex. Damit kann die optische Resonatorlänge und die spektrale Lage der FP-Moden elektrisch eingestellt werden. Zur Verringerung des technologischen Aufwandes bei der Herstellung der Schichtstruktur wurde auf die Anordnung der p-Wellenleiterschicht **4** in der passiven Steuersektion **S**_{**p**} verzichtet. Das Prinzip der erfindungsgemäßen Lösung wird dadurch nicht berührt.

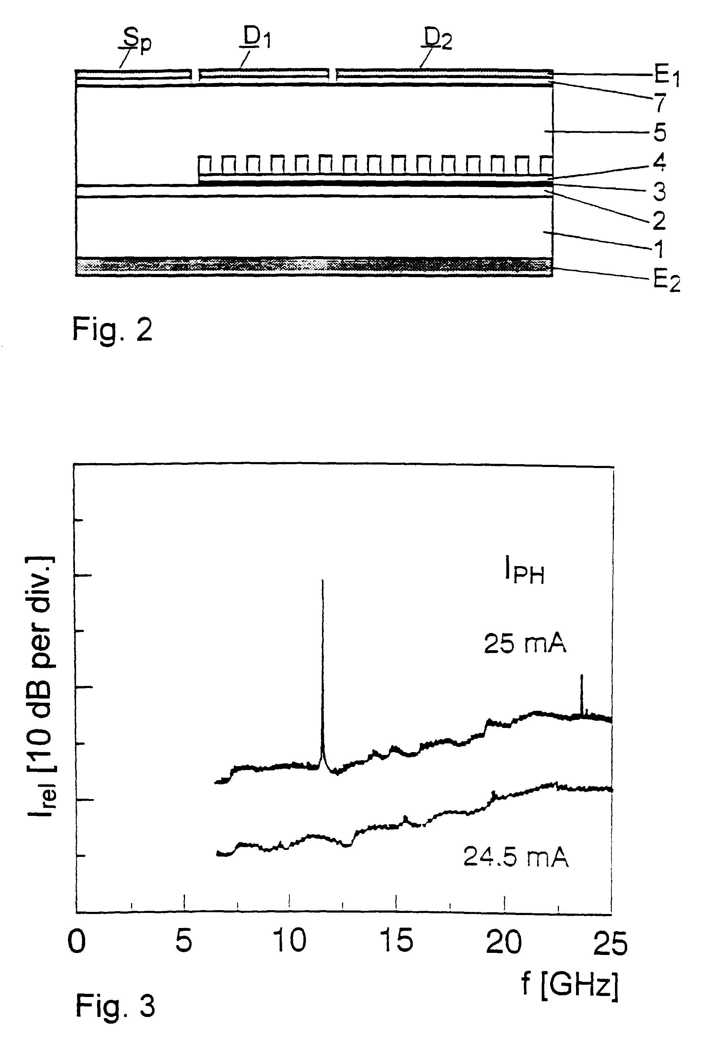

In Fig. 2 ist der gleiche beschriebene Mehrsektionslaser im Querschnitt schematisch dargestellt. Der Schnitt wurde in Längsrichtung durch den erhöhten Mittelstreifen der Rippenwellenleiterstruktur geführt und läßt die ähnliche Schichtstruktur der passiven Steuersektion **S**_{**p**} und der beiden DFB-Sektionen **D**_{**1**} und **D**_{**2**} gut erkennen. Die Schichtstruktur weist folgende Schichten auf: eine Basiselektrode **E**_{**2**}, ein n-InP-Substrat 1, eine n-InGaAsP-Wellenleiterschicht **2**, eine aktive InGaAsP-Schicht **3**, eine p-InGaAs-Wellenleiterschicht **4** mit DFB-Gitter, eine p-InP-Schicht **5**, eine p-InGaAs-Schicht **7** und eine sektionsweise elektrisch getrennte Deckelektrode **E**_{**1**}.

Das Schalten der Selbstpulsation des erfindungsgemäßen Mehrsektionslasers ist anhand der Fig. 3 deutlich zu erkennen. Dargestellt ist die relative Intensität **I**_{**re1**} von Leistungsmodulationen in Abhängigkeit von deren Frequenz **f** bei unterschiedlichen Strömen **I**_{**PH**} in der Steuersektion **S**_{**p**}, die die Phasenlage des reflektierten Lichtstrahls bzw. die FP-Modenbedingung ändern. Das Einschalten von Selbstpulsationen der Frequenz 12 GHz ist erkennbar. Der Strom in den beiden DFB-Sektionen wurde Werten angepaßt, bei denen der Mehrsektionslaser eine Monomode-Emission zeigt und bei denen das Einsetzen der Selbstpulsation erwartet werden kann. Die DFB-Sektion **D**_{**2**} wurde mit 8mA als Reflektor betrieben, die Sektion **D**_{**1**} bei 140 mA als Lasersektion. Unter diesen Bedingungen wurde der Strom **I**_{**PH**} in der phasenabstimmbaren Steuersektion **S**_{**p**} variiert, um eine Selbstpulsation zu erreichen. Es konnte festgestellt werden, daß bei kritischen Phasenströmen **I**_{**PH**} nur eine geringe Änderung dieses Parameters entscheidend ist für eine drastische Änderung des Spektrums. Das untere Spektrum bei **I**_{**PH**} = 24,5 mA entspricht einem Laser mit konstanter Emission, mit Erhöhen des Phasenstromes **I**_{**PH**} auf 25 mA konnte das Einsetzen der Selbstpulsation eindeutig nachgewiesen werden. Damit wird deutlich, daß einfach durch Abstimmen der Phasenbedingungen in der passiven Steuersektion die Selbstpulsation in dem erfindungsgemäßen Mehrsektionslaser ein- und ausgeschaltet werden kann.

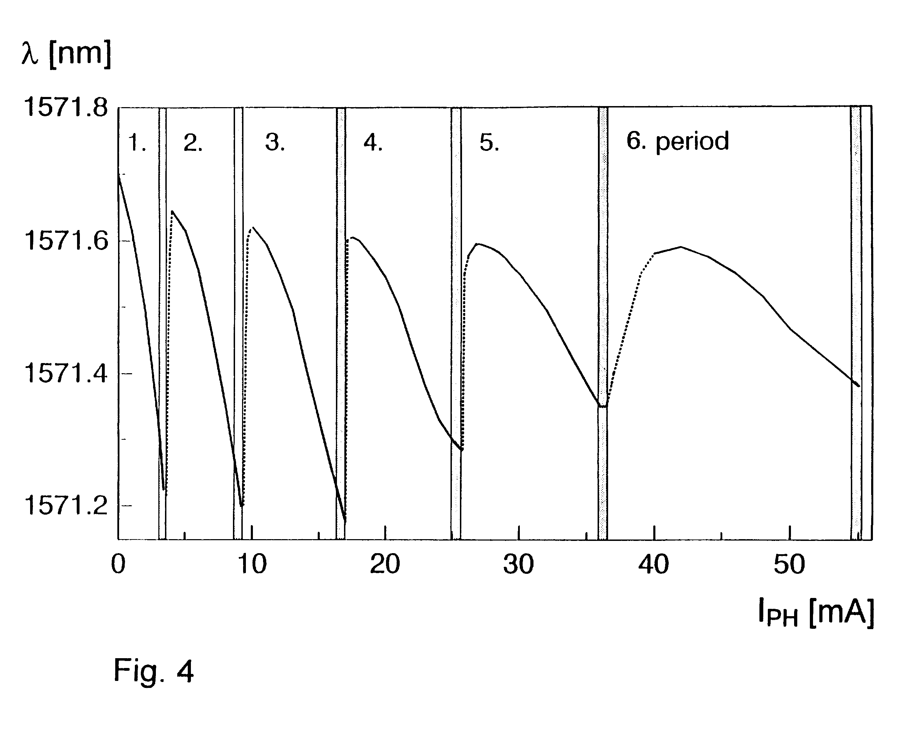

Dieser Schalteffekt in Korrelation mit der Wellenlängenabstimmung über den Phasenstrom ist in Fig. 4 dargestellt. Die Laserwellenlänge λ zeigt eine kontinuierliche Blau-Verschiebung mit anschließendem periodischen Sprung zu etwa 0,5 nm größeren Wellenlängen. Die Pulsationsregime sind dunkel markiert, und sie treten mit genau derselben Periodizität vom Phasenstrom **I**_{**PH**} auf Die Selbstpulsation wird immer dann erreicht, wenn die Laserwellenlänge λ - bei richtig eingestellten DFB-Strömen - auf den Bereich kurz vor dem Wellenlängensprung abgestimmt wird. Die Schaltfunktion des Phasenstromes sowie die enge Korrelation mit dem spektralen Verhalten sind hier deutlich zu erkennen.

Die weiteren Figuren zeigen Beispiele für Anordnungen der Steuersektion zwischen den beiden DFB-Sektionen **D**_{**1**} und **D**_{**2**}. Diese Anordnungen gestatten die Integrierung des Mehrsektionslasers in optische Schaltkreise. In den Figuren sind schematisch die entsprechenden Querschnitte durch den erhöhten Mittelstreifen der Rippenwellenleiterstruktur dargestellt.

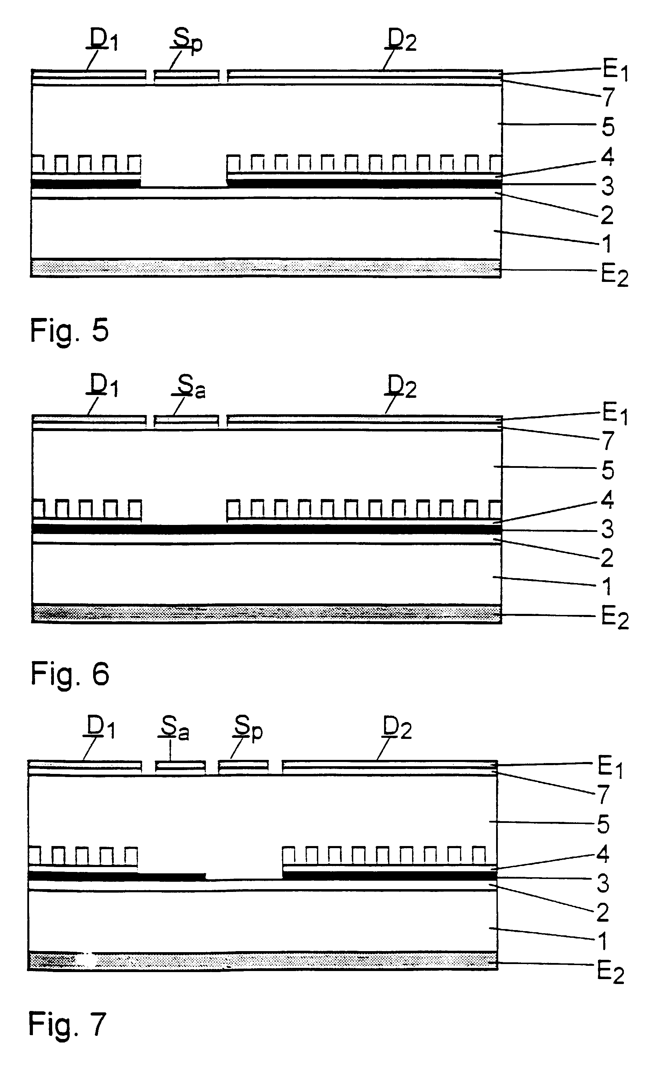

So ist in Fig. 5 die passive Steuersektion **S**_{**p**} zwischen den beiden DFB-Sektionen **D**_{**1**} und **D**_{**2**} angeordnet. Hierbei ist der Brechungsindex der Steuersektion **S**_{**p**} veränderbar über den an diese Sektion angelegten Strom. Fig. 6 zeigt die Anordnung eines als aktive Steuersektion **S**_{**a**} ausgebildeten Distanzstücks im FP-Resonator ebenfalls zwischen den beiden DFB-Sektionen **D**_{**1**} und **D**_{**2**}. Die aktive Steuersektion **S**_{**a**} weist die gleiche aktive Schicht **3** wie die benachbarten DFB-Sektionen **D**_{**1**} und **D**_{**2**} auf. Die aktive Schicht **3** ermöglicht die Steuerung der Dämpfung oder der Verstärkung der Lichtwelle bei nur schwachem Brechungsindex-Effekt über den Strom. Die in Fig. 7 dargestellte Kombination aus den beiden bereits erwähnten Sektionen, d.h. sowohl eine aktive Steuersektion **S**_{**a**} als auch eine passive Steuersektion **S**_{**p**} sind zwischen den beiden DFB-Sektionen **D**_{**1**} und **D**_{**2**} angeordnet, ermöglicht die separate Veränderung des Brechungsindex und der Verstärkung bzw. Dämpfung.

Die Erfindung beschränkt sich in ihrer. Ausführung nicht auf die vorstehend beschriebenen bevorzugten Ausführungsbeispiele, da auch Varianten denkbar sind, die von der vorliegenden Lösung ebenfalls bei grundsätzlich anders gearteten Ausführungen Gebrauch machen.

Der erfindungsgemäße selbstpulsierende Zwei-Sektions-DFB-Laser mit integrierter Steuersektion ist zur optischen Taktregeneration in hochratigen Kommunikationssystemen anwendbar, weil sich die Selbstpulsation durch inhärente Effekte bezüglich optischer Signalströme selbst synchronisieren kann, d.h. das periodische Ausgangssignal kann in Frequenz und Takt eines optisch eingespeisten Datensignals "einrasten". Der Takt des Datensignals kann überall im Netz wiedergewonnen werden. Die integrierte Steuersektion ermöglicht erstmals das Ein- und Ausschalten der Selbstpulsation, die Optimierung der Selbstpulsation und eine gezielte Variation der Wellenlänge der Lasermode. Da die Ausgangsleistung des erfindungsgemäßen Mehrsektionslasers um einige Größenordnungen größer ist als die benötigte Pumpleistung zum Synchronisieren der Frequenz, kann der selbstpulsierende Zwei-Sektions-DFB-Laser mit integrierter Steuersektion auch zur Pulsverstärkung genutzt werden. Ebenfalls möglich ist aufgrund der beschriebenen Eigenschaften sein Einsatz als frequenzabstimmbare Pulslichtquelle.

## Patentansprüche

1. Selbstpulsierender Mehrsektionslaser, der zwei DFB-Sektionen aufweist,
**dadurch gekennzeichnet, daß**
ein aus zwei Reflektoren und einem Distanzstück gebildeter Fabry-Perot-artiger Resonator in den Mehrsektionslaser integriert und mit mindestens einer DFB-Sektion optisch gekoppelt ist und das Distanzstück eine ähnliche Schichtstruktur wie die benachbarten DFB-Sektionen (D₁) und (D₂), jedoch kein DFB-Gitter, aufweist und als elektrisch von den DFB-Sektionen getrennt betreibbare Steuersektion ausgebildet ist, um über die Fabry-Perot Selektivität die zur Selbstpulsation geeignete Mode gezielt zu fördern oder zu unterdrücken.

2. Selbstpulsierender Mehrsektionslaser nach Anspruch 1,
**dadurch gekennzeichnet, daß**
das Distanzstück als passive Steuersektion (Sₚ) ausgebildet ist und keine aktive Schicht aufweist.

3. Selbstpulsierender Mehrsektionslaser nach Anspruch 2,
**dadurch gekennzeichnet, daß**
die passive Steuersektion (Sp) zwischen einer DFB-Sektion (D₁) bzw. (D₂) und einer den Mehrsektionslaser begrenzenden Facette (F₁) angeordnet ist.

4. Selbstpulsierender Mehrsektionslaser nach Anspruch 2,
**dadurch gekennzeichnet, daß**
die passive Steuersektion (Sp) zwischen den beiden DFB-Sektionen (D₁) und (D₂) angeordnet ist.

5. Selbstpulsierender Mehrsektionslaser nach Anspruch 1,
**dadurch gekennzeichnet, daß**
das Distanzstück als aktive Steuersektion (Sₐ) ausgebildet und zwischen den beiden DFB-Sektionen (D₁, D₂) angeordnet ist und die gleiche aktive Schicht (3) wie die benachbarten DFB-Sektionen (D₁), (D₂) aufweist.

6. Selbstpulsierender Mehrsektionslaser nach Anspruch 2, 4 und 5,
**dadurch gekennzeichnet, daß**
das Distanzstück sowohl aus einer aktiven als auch aus einer passiven Steuersektion (Sₐ) und (Sp) besteht, zwischen den beiden DFB-Sektionen (D₁) und (D₂) angeordnet ist und daß die beiden Steuersektionen (Sₐ) und (Sp) getrennt elektrisch ansteuerbar sind.

7. Selbstpulsierender Mehrsektionslaser nach einem der Ansprüche 1 bis 6,
**dadurch gekennzeichnet, daß**
die Gitter in den beiden DFB-Sektionen (D₁) und (D₂) verstimmt gegeneinander in der Bragg-Wellenlänge sind.

8. Selbstpulsierender Mehrsektionslaser nach einem der Ansprüche 1 bis 7,
**dadurch gekennzeichnet, daß**
die Gitter in den beiden DFB-Sektionen (D₁) und (D₂) unterschiedlich große Kopplungskoeffizienten aufweisen.

## Claims

1. Self-pulsing multi-section laser provided with two DFB sections,
characterized by the fact that
a Fabry-Perot-like resonator made of two reflectors and a spacer is integrated into the multi-section laser and is optically coupled with at least one DFB section and that the spacer is of a similar layer structure as the adjacent DFB sections (D₁) and (D₂) but is not provided with a DFB grid, and is structured as a control section operable in electrical separation from the DFB sections for purposeful supporting or surpressing the suitable mode for self pulsation via Fabry-Perot-selectivity.

2. Self-pulsing multi-section laser according to claim 1,
characterized by the fact that
the spacer ist structured as a passive control section (Sₚ) and is provided with no active layer.

3. Self-pulsing multi-section laser according to claim 2,
characterized by the fact that
the passive control section (Sₚ) is arranged between a DFB section (D₁) or (D₂) and facet (F₁) limiting the multi-section laser.

4. Self-pulsing multi-section laser according to claim 2,
characterized by the fact that
the passive control section (Sₚ) is arranged between the two DFB sections (D₁) and (D₂).

5. Self-pulsing multi-section laser according to claim 1,
characterized by the fact that
the spacer is structured as an active control section (Sₐ) and is arranged between the two DFB sections (D₁, D₂) and is provided with the same active layer (3) as the adjacent DFB sections (D₁), (D₂).

6. Self-pulsing multi-section laser according to claim 2, 4 and 5,
characterized by the fact that
the spacer consists of an active as well as a passive control section (Sₐ) and (Sₚ), is arranged between the two DFB sections (D₁) and (D₂) and that the two control sections (Sₐ) and (Sₚ) may be separately electrically controlled.

7. Self-pulsing multi-section laser according to one of the claims 1 to 6,
characterized by the fact that
that the grids in the two DFB sections (D1) and (D2) are detuned in the Bragg wavelength relative to each other.

8. Self-pulsing multi-section laser according to one of the claims 1 to 7,
characterized by the fact that
the grids in the two DFB sections (D₁) and (D₂) have differently valued coupling coefficients.

## Revendications

1. Laser à plusieurs sections à auto-impulsion comprenant deux sections DFB,
caractérisé par
un résonateur Fabry-Perot formé de deux réflecteurs et d'une pièce d'écartement intégrés dans le laser à plusieurs sections,
- au moins une section DFB (section à réaction distribuée) est couplée optiquement,
- la pièce d'écartement a une structure analogue à une structure en couches comme les sections DFB voisines (D₁) et (D₂) sans toutefois avoir de grille DFB et cette pièce est réalisée comme section de commande fonctionnant électriquement de manière séparée des sections DFB, pour mettre en oeuvre ou éliminer, par la sélectivité de Fabry-Perot, les modes convenant pour l'autopulsation.

2. Laser à plusieurs sections à auto-impulsion selon la revendication 1,
caractérisé en ce que
la pièce d'écartement est une section de commande passive (Sₚ) et ne comporte pas de couches actives.

3. Laser à plusieurs sections à auto-impulsion selon la revendication 2,
caractérisé en ce que
la section de commande passive (Sₚ) est prévue entre une section DFB (D₁, D₂) et une facette (F₁) délimitant le laser à plusieurs sections.

4. Laser à plusieurs sections à auto-impulsion selon la revendication 2,
caractérisé en ce que
la section de commande passive (Sₚ) est prévue entre deux sections DFB, (D₁, D₂).

5. Laser à plusieurs sections à auto-impulsion selon la revendication 1,
caractérisé en ce que
la pièce d'écartement est en forme de section de commande active (Sₐ) et se trouve entre les deux sections DFB, (D₁, D₂) et comporte la même couche active (3) que les sections DFB voisines (D₁, D₂).

6. Laser à plusieurs sections à auto-impulsion selon les revendications 2, 4, 5,
caractérisé en ce que
la pièce d'écartement se compose à la fois d'une section de commande active (Sₐ) et d'une section de commande passive (Sₚ), entre lesquelles se trouvent les deux sections DFB (D₁, D₂) et en ce que les deux sections de commande (Sₐ) et (Sₚ) sont commandées électriquement de manière séparée.

7. Laser à plusieurs sections à auto-impulsion selon l'une des revendications 1 à 6,
caractérisé en ce que les grilles des deux sections DFB, (D₁, D₂) sont désaccordées par leur longueur d'onde de Bragg.

8. Laser à plusieurs sections à auto-impulsion selon l'une des revendications 1 à 7,
caractérisé en ce que
les grilles des deux sections DFB, (D₁, D₂) ont des coefficients de couplage différents.
